# EUROPEAN PATENT SPECIFICATION

(11) **EP 1 183 921 B1**
(45) Date of publication and mention of the grant of the patent: **14.01.2004**
(21) Application number: 01919974.4
(22) Date of filing: 17.04.2001
(51) Int. Cl.: H05K 9/00, H04M 1/02

(54) **HIGH-FREQUENCY CURRENT SUPRESSOR CAPABLE OF BEING READILY ATTACHED TO CABLE OR THE LIKE AND EARPHONE SYSTEM USING THE SAME**
AN EINEM KABEL ODER DERGLEICHEN ZU BEFESTIGENDE HOCHFREQUENZ-ENTSTÖRVORRICHTUNG SOWIE DIESE VERWENDENDE HÖRKAPSEL
DISPOSITIF DE SUPPRESSION DE COURANT HAUTE FREQUENCE SE FIXANT FACILEMENT SUR UN CABLE OU ANALOGUE ET SYSTEME D'ECOUTEUR EQUIPE D'UN TEL DISPOSITIF

(30) Priority: 17.04.2000 JP 2000114912; 27.04.2000 JP 2000127191
(43) Date of publication of application: 06.03.2002
(73) Proprietor: NEC TOKIN Corporation, Sendai-shi, Miyagi (JP)
(72) Inventor: ONO, Hiroshi, NEC TOKIN Corporation, Sendai-shi, Miyagi 982-8510 (JP); YOSHIDA, Shigeyoshi, NEC TOKIN Corporation, Sendai-shi, Miyagi 982-8510 (JP)
(74) Representative: Prüfer, Lutz H., Dipl.-Phys.
(86) International application number: PCT/JP2001/003271
(87) International publication number: WO 2001/080616

(56) References cited:
- DE-A- 19 909 569
- FR-A- 2 765 069
- US-A- 4 742 887
- US-A- 5 703 557
- PATENT ABSTRACTS OF JAPAN vol. 1999, no. 09, 30 July 1999 (1999-07-30) & JP 11 097246 A (TOKIN CORP), 9 April 1999 (1999-04-09)

## Description

### TECHNICAL FIELD:

The present invention relates to a high-frequency current suppressor for suppressing high-frequency conduction noise in a signal transmission cable used for an earphone system, and also to an earphone system using the high-frequency current suppressor.

### BACKGROUND ART:

Conventionally, various signal transmission cables are used for transmitting signals between devices or between components in various electronic information equipment.

On the other hand, in various audio-visual equipment for enjoying music or movies, an earphone system including a signal transmission cable having a connection plug at its end, earphone or headphone is utilized to enable a user to enjoy music or movies without worrying about surrounding sound.

Further, an earphone system combining the above-described earphone or headphone for enjoying music etc. and a microphone has been used in recent years, for example, in a terminal equipment for mobile communication, such as a portable telephone, or the like. This makes hands-free communication available, namely makes it unnecessary for a user to hold the terminal equipment for mobile communication directly in his hand.

The earphone system including those earphones or headphones generally comprises a connection plug connected to an output terminal of a terminal equipment, an earphone or a headphone and/or a microphone, and a signal cable for connecting the connection plug with the earphone, or the like. A cable length of the signal cable ranges from several tens centimeters to a hundred and several tens centimeters. In addition, the cable length corresponds to order of wavelength in microwave band used for mobile communication.

However, an output from antenna attached to a terminal equipment for mobile communication, such as a portable telephone, or the like is easily conducted to the signal cable of the earphone system due to electromagnetic coupling. As a result, electromagnetic wave is conducted to a head of the user through the signal cable. This sometimes increases localized SAR (absorbed electric power per specific weight) value.

Thus, electromagnetic waves produced from a terminal equipment for mobile communication or the like cause a problem in which an influence of the electromagnetic waves to a human body becomes serious.

Various researches have been made in recent years as regards such an influence of the electromagnetic waves to a human body. It is sure that the influence would become serious problem more and more from now on in accordance with further popularization of the mobile communication equipment. In addition, unnecessary high-frequency noise (current) is sometimes conducted to a signal cable used for transmitting signals between devices or between components in various electronic information equipment. An erroneous operation of electronic information equipment is thereby caused to occur.

The DE-A1-199 09 569 discloses a composite magnetic tape comprising a magnetic body, which comprises ferrite powder as a magnetic powder and a binding material, and a metal foil.

It is therefore an object of the. present invention to provide a high-frequency current suppressor which is capable of being readily attached to a signal cable used for transmitting signals between devices or between components in various electronic information equipment and which can prevent the electronic information equipment from erroneous operations by reducing unnecessary high-frequency current conducted to the signal cable.

It is another object of the present invention to provide a high-frequency current suppressor which is capable of being readily attached to an earphone, a signal cable, or the like, and which can prevent electromagnetic wave from increasing SAR value in a human head by reducing unnecessary high-frequency current generated in the signal cable due to induction of the electromagnetic wave produced from a terminal equipment, and the like, and also to provide an earphone system using the high-frequency current suppressor.

### DISCLOSURE OF THE INVENTION:

The present invention provides an earphone system as defined in claim 1. Preferred embodiments of the earphone system are set forth in the sub claims.

Besides, " earphone system" depicted in the present invention includes not only a system having one earphone (for use in a single ear) or two earphones (for use in both ears) but also another system having, what we call, a headphone combining two earphones (for use in both ears) and a head band etc..

### BRIEF DESCRIPTION OF THE DRAWINGS:

Fig. 1 is an explanation view for showing a high-frequency current suppressor according to a first embodiment of the present invention, (a) is a schematic perspective view showing the high-frequency current suppressor, (b) is a schematic perspective view showing a condition in which the high-frequency current suppressor is attached to a cable;
Fig. 2 is a schematic perspective view for showing a high-frequency current suppressor according to a second embodiment of the present invention;
Fig. 3 is a schematic perspective view for showing a high-frequency current suppressor according to a third embodiment of the present invention;
Fig. 4 is a schematic perspective view for showing a high-frequency current suppressor according to a fourth embodiment (reference embodiment);
Fig. 5 is a view for showing suppressing effects against high-frequency electromagnetic waves in the high-frequency current suppressor according to the first through the fourth embodiments;
Fig. 6 is an explanation view for showing an earphone system according to a fifth embodiment of the present invention, (a) is a schematic perspective view showing the earphone system, (b) is an enlarged view showing a high-frequency current suppressor thereof;
Fig. 7 is an explanation view for showing an earphone system according to a sixth embodiment of the present invention, (a) is a schematic perspective view showing the earphone system, (b) is an enlarged view showing a high-frequency current suppressor thereof;
Fig. 8 is an explanation view for showing an earphone system according to a seventh embodiment (reference embodiment), (a) is a schematic perspective view showing the earphone system, (b) is an enlarged view showing a high-frequency current suppressor thereof;
Fig. 9 is an explanation view for showing an earphone system accordin g to an eighth embodiment (reference embodiment), (a) is a schematic perspective view showing the earphone system, (b) is an enlarged sectional view showing an earphone thereof;
Fig. 10 is an enlarged sectional view for showing a microphone of an earphone system according to an ninth embodiment (reference embodiment);
Fig. 11 is an enlarged view for showing an earphone of an earphone system according to a tenth embodiment of the present invention;
Fig. 12 is an enlarged view for showing a microphone of an earphone system according to an eleventh embodiment of the present invention; and
Fig. 13 is a view for showing measuring effects of suppressing effect against high-frequency electromagnetic waves in the earphone system using the high-frequency current suppressor according to the fifth through the ninth embodiments.

### BEST MODE FOR EMBODYING THE INVENTION:

### (First Embodiment)

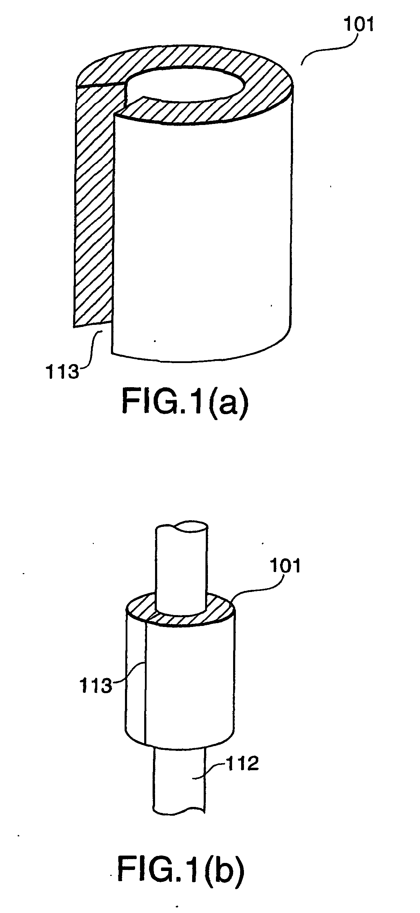

Referring to Figs. 1(a) and 1(b), description is, at first, made about a high-frequency current suppressor according to a first embodiment of the present invention.

In Fig. 1(a), a high-frequency current suppressor 101 is essentially consisting of a composite magnetic material which comprises soft magnetic powder obtained by flattening alloy powder including Fe, Si, Al, and a binding material. The composite magnetic material is subjected to press molding to have a cylindrical shape having a size of 1.5 mm in inner diameter, 2.65 mm in outer diameter, and 10.0 mm in length. The composite magnetic material has a break 113 which elongates length direction of the cylindrical shape in a part thereof. The composite magnetic material is thereby formed to have flexibility.

On the other hand, Fig. 1(b) shows a condition in which the high-frequency current suppressor 101 consisting of this composite magnetic material is attached to a signal cable 112 having a size of approximately 1.5 mm in outer diameter. The high-frequency current suppressor 101 has flexibility, as mentioned above. Let the break 113 of the high-frequency current suppressor 101 be opened by a hand or fingers to be attached to the signal cable 112 and release the high-frequency current suppressor 101 from the hand or fingers. Accordingly, the high-frequency current suppressor 101 is adhered and fixed to the signal cable 112.

In the interim, suppressing effects against high-frequency current was investigated as regards the high-frequency current suppressor 101 according to this embodiment, after the high-frequency current suppressor 101 was fixed to the signal cable 112. As a result, a suppressing effect of -17dB is obtained at such a frequency band of 900 MHz as used for mobile communication while another suppressing effect of -27dB is obtained at such a frequency band of 1.9 GHz as also used therefor.

In the first embodiment, the high-frequency current suppressor 101 is consisting of the composite magnetic material which comprises soft magnetic powder obtained by flattening alloy powder including Fe, Si, and Al, and a binding material. However, the alloy powder is not required to include all of Fe, Si, and Al. The alloy powder is required to include at least any one of Fe, Si, Al.

### (Second Embodiment)

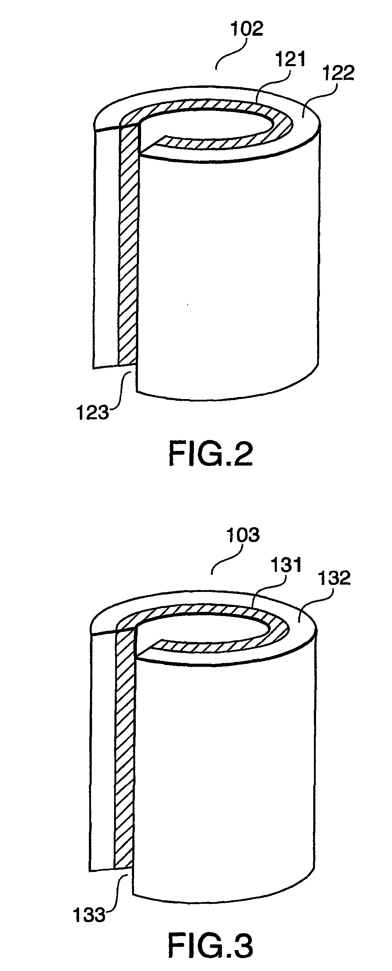

Next, referring to Fig. 2, description will proceed to a high-frequency current suppressor according to a second embodiment of the present invention.

In Fig. 2, a high-frequency current suppressor 102 comprises two layers which consist of a high-frequency current suppressing layer 121 and a resin outer layer 122. The high-frequency current suppressing layer 121 is essentially consisting of a composite magnetic material to have flexibility, similar to that of the first embodiment. An outer circumference of the high-frequency current suppressing layer 121 is covered by the resin outer layer 122 consisting of molded resin having a thickness of approximately 0.5 'mm to have flexibility.

Also in the high-frequency current suppressor 102, similarly to the first embodiment, both the high-frequency current suppressing layer 121 and the resin outer layer 122 have flexibility. Let the break 123 of the high-frequency current suppressor 102 be opened by a hand or fingers to be attached to the signal cable 112(See Fig. 1) and release the high-frequency current suppressor 102 from the hand or fingers. Accordingly, the high-frequency current suppressor 102 is adhered and fixed to the signal cable 112(See Fig. 1).

Further, suppressing effects against high-frequency current was investigated as regards the high-frequency current suppressor 102, after being fixed to the signal cable 112(See Fig. 1). As a result, a suppressing effect of -18dB is obtained at such a frequency band of 900 MHz as used for mobile communication while another suppressing effect of -29dB is obtained at such a frequency band of 1.9 GHz as also used therefor.

### (Third Embodiment)

Continuously, referring to Fig. 3, description proceeds to a high-frequency current suppressor according to a third embodiment of the present invention.

In Fig. 3, a high-frequency current suppressor 103 comprises two layers which consist of a high-frequency current suppressing layer 131 and an aluminum outer layer 132. The high-frequency current suppressing layer 131 is essentially consisting of a composite magnetic material to have flexibility, similar to that of the first embodiment. An outer circumference of the high-frequency current suppressing layer 131 is covered by the aluminum outer layer 132 consisting of molded aluminum having a thickness of approximately 0.3 mm to have flexibility.

Also in the high-frequency current suppressor 103, similarly to the second embodiment, both the high-frequency current suppressing layer 131 and the aluminum outer layer 132 have flexibility. Let the break 133 of the high-frequency current suppressor 103 be opened by a hand or fingers to be attached to the signal cable 112(See Fig. 1) and release the high-frequency current suppressor 103 from the hand or fingers. Accordingly, the high-frequency current suppressor 103 is adhered and fixed to the signal cable 112(See Fig. 1).

Further, suppressing effects against high-frequency current was investigated as regards the high-frequency current suppressor 103, after being fixed to the signal cable 112(See Fig. 1). As a result, a suppressing effect of -17dB is obtained at such a frequency band of 900 MHz as used for mobile communication while another suppressing effect of -32dB is obtained at such a frequency band of 1.9 GHz as also used therefor.

As described above, the outer layer 122 is consisting of molded resin in the second embodiment while the outer layer 132 is consisting of molded metal (aluminum) in the third embodiment. However, the outer layer can be consisting of combination of both resin and metal.

### (Fourth Embodiment) (Reference Embodiment)

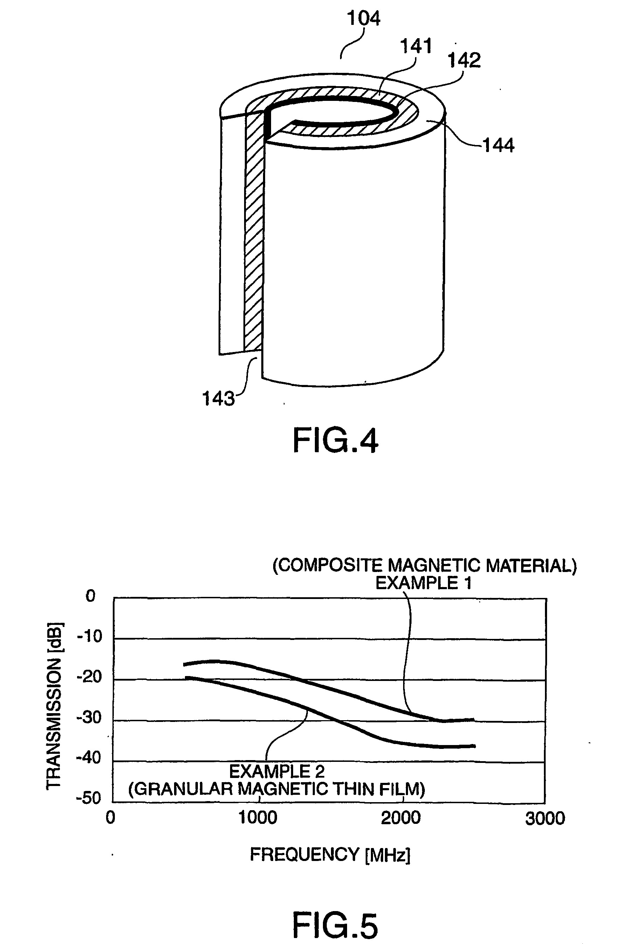

Further, referring to Fig. 4, description proceeds to a high-frequency current suppressor according to a fourth embodiment.

In Fig. 4, a high-frequency current suppressor 104 has three-layers structure which comprises a high-frequency current suppressing layer 141, a polyimide base material 142 and a resin outer layer 144. The high-frequency current suppressing layer 141 has flexibility and is consisting of magnetic loss thin film (granular magnetic thin film) composed of Fe₇₂Al₁₁O₁₇. The polyimide base material 142 has a thickness of approximately 0.2 mm to have flexibility. The resin outer layer 144 is consisting of molded resin having a thickness of approximately 0.5 mm to have flexibility. In order to fabricate these three-layers structure, at first, the high-frequency current suppressing layer 141 is formed on a surface of the polyimide base material 142 by sputtering to have a film thickness of 1.5 µm. Thereby, the high-frequency current suppressing layer 141 and the polyimide base material 142 are formed to have a cylindrical shape having approximately 1.5 mm in inner diameter, and approximately 10.0 mm in length. An outer circumference of the high-frequency current suppressing layer 141 is then covered by the resin outer layer 144 consisting of molded resin having a thickness of approximately 0.5 mm to have flexibility.

Also in the high-frequency current suppressor 104, similarly to the second and the third embodiments, all of the high-frequency current suppressing layer 141, the polyimide base material 142 and the resin outer layer 144 have flexibility. Let the break 143 of the high-frequency current suppressor 104 be opened by a hand or fingers to be attached to the signal cable 112(See Fig. 1) and release the high-frequency current suppressor 104 from the hand or fingers. Accordingly, the high-frequency current suppressor 104 is adhered and fixed to the signal cable 112(See Fig. 1).

Further, suppressing effects against high-frequency current was investigated as regards the high-frequency current suppressor 104, after being fixed to the signal cable 112(See Fig. 1). As a result, a suppressing effect of -23dB is obtained at such a frequency band of 900 MHz as used for mobile communication while another suppressing effect of -35dB is obtained at such a frequency band of 1.9 GHz as also used therefor.

Herein, Fig. 5 shows suppressing effects against high-frequency electromagnetic waves in the high-frequency current suppressors according to the first through the fourth embodiments.

In Fig. 5, EXAMPLE 1 shows measuring effects of transmission characteristics by a network analyzer between two ports. In these measuring, the high-frequency current suppressors 101, 102 and 103 according to the first through the third embodiments are attached to be fixed to a central portion in the length direction of the cable having 1.5 mm in outer diameter and 300 mm in length. Then, both ends of the cable are connected to the network analyzer, as the above-mentioned two ports.

On the other hand, EXAMPLE 2 shows measuring effect of transmission characteristics by a network analyzer between two ports. In this measuring, the high-frequency current suppressor 104 according to the fourth embodiment is attached to be fixed to the central portion of the cable, and then both ends of the cable are connected to the network analyzer, similarly to the EXAMPLE 1.

As will be understood from Fig. 5, according to EXAMPLE 1 and EXAMPLE 2, suppressing effects between 25dB and 35dB can be obtained at quasi-microwave band in any high-frequency current suppressors 101, 102, 103 and 104.

Besides, other than the high-frequency current suppressors 101, 102, 103 and 104, alternative high-frequency current suppressors can be designed by changing material composition or size thereof. Accordingly, desirable suppressing characteristics can be obtained by adapting the material composition or the size of the high-frequency current suppressors to a cable.

Further, other than the high-frequency current suppressors according to the above-mentioned first through fourth embodiments, it will now be readily possible to put this invention into effect in various other manners. For example, a break 113, 123, 133 or 143 was formed to be a substantially straight line parallel to an axis of the cylindrical shape of the high-frequency current suppressors. The break can be formed to have an angle to the axis of the cylindrical shape. In addition, the break can be formed as a curve. Alternatively, the break can be composed of two edges interfitted to each other when the break is closed. In addition, shapes of the high-frequency current suppressors are not limited to the cylindrical shape. The high-frequency current suppressors can be formed to have a rectangular shape. Further, a member for preventing the cable from slipping or an adhesive layer can be provided at inner side of the cylindrical or the rectangular tube.

As described above, according to the first through the fourth embodiments of the present invention, the high-frequency current suppressors 101, 102, 103 or 104 comprises a flexible member capable of being attached to a cable. Furthermore, the flexible member comprises a break which elongates over all length along an axial direction of the cable. The high-frequency current suppressors 101, 102, 103 or 104 can therefore be readily attached and fixed to a signal cable used for an earphone, a microphone, and the other electronic equipments. Excellent suppressing effects can be obtained at quasi-microwave band in any high-frequency current suppressors 101, 102, 103 and 104. Accordingly, it is possible to provide a high-frequency current suppressor which can suppress unnecessary high-frequency current sufficiently and which is thereby effective to solve various EMI (electromagnetic interference) problems. It is also possible to prevent electromagnetic waves from increasing SAR value in a human head by applying the high-frequency current suppressor 101, 102, 103 or 104 to earphone, headphone or a signal cable connecting those to a terminal equipment for mobile communication.

Next, referring to drawings, description will proceed to an earphone system according to a fifth through an eleventh embodiments of the present invention.

### (Fifth Embodiment)

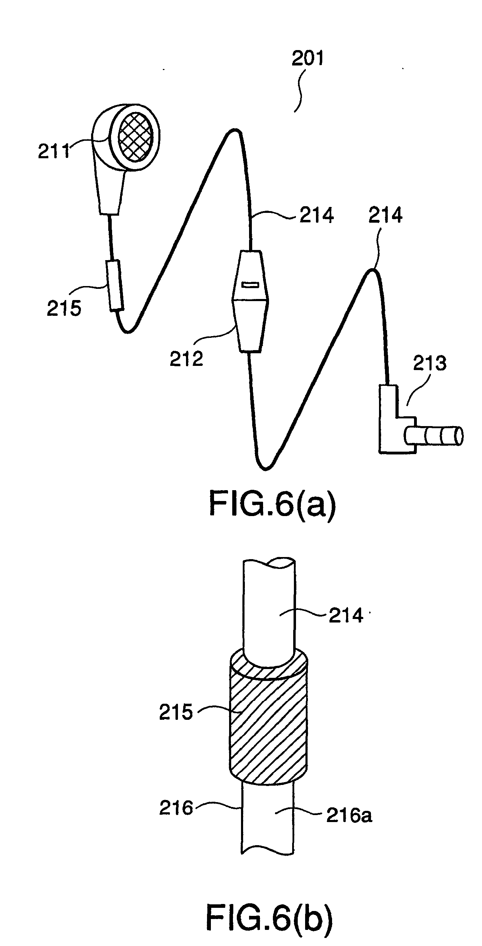

Referring to Figs. 6(a) and 6(b), description is, at first, made about an earphone system according to a fifth embodiment of the present invention.

As illustrated in Fig. 6(a), an earphone system 201 comprises an earphone 211, a microphone 212, a connection plug 213, and a signal cable 214 for connecting the earphone 211 and the microphone 212 as well as the microphone 212 and the connection plug 213. The signal cable 214 comprises unillustrated an inner conductor, an outer conductor and insulation coating over those inner conductor and outer conductor. Further, as illustrated in Fig. 6(b), the signal cable 214 is overlaid by a cable housing 216 over all of the length thereof. Further, the earphone system 201 comprises a high-frequency current suppressor 215 attached to the signal cable 214 at a position near the earphone 211 with covering an external circumuferencial surface 216a of the cable housing 216 at the position.

The high-frequency current suppressor 215 is formed to have a hollow cylindrical shape having a size of 1.55 mm in inner diameter, 2.20 mm in outer diameter, and 10.0 mm in length, as illustrated in Fig. 6(b). As illustrated in Figs. 6(a) and 6(b), the high-frequency current suppressor 215 is fixed to the signal cable 214 at the position near the earphone 211 with an internal circumference thereof being adhered to an external circumferencial surface 216a of the cable housing 216.

Herein, the high-frequency current suppressor 215 is consisting of composite magnetic material which comprises soft magnetic powder obtained by flattening alloy powder including Fe, Si, Al, and binding material. The high-frequency current suppressor 215 is formed by press molding to have the above-mentioned hollow cylindrical shape and the size.

### (Sixth Embodiment)

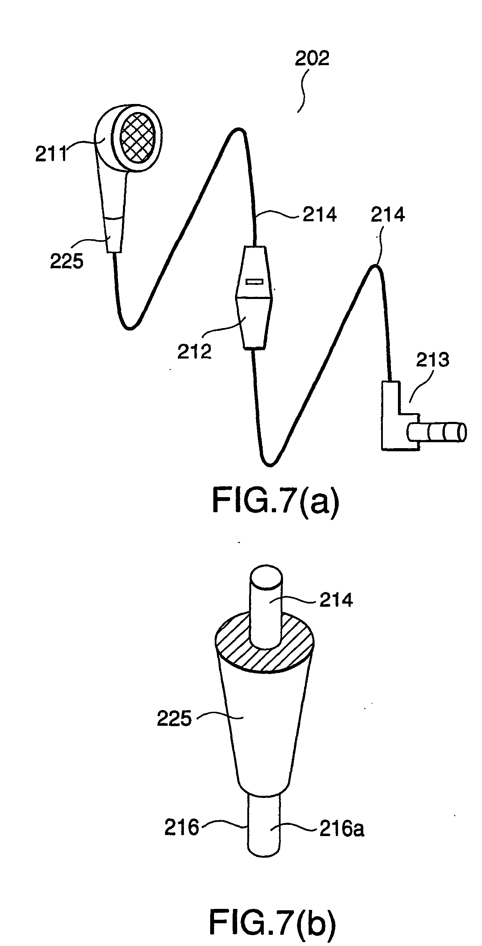

Referring to Figs. 7(a) and 7(b), description will proceed to an earphone system according to a sixth embodiment of the present invention. The earphone system according to the sixth embodiment has a structure basically similar to that of the fifth embodiment illustrated in Figs. 6(a) and 6(b). Similar portions are therefore designated by like reference numerals and detailed description thereof is omitted accordingly.

As illustrated in Fig. 7(a), an earphone system 202 comprises a high frequency current suppressor 225 attached to an end of the earphone 211 in series. The high-frequency current suppressor 225 is formed to have a hollow taper shape having a size of 1.55 mm in inner diameter, 3.30 mm in outer diameter of the uppest portions, 2.0 mm in outer diameter of the lowest portions, and 5.5 mm in length of the taper portion, as illustrated in Fig. 7(b). As illustrated in Figs. 7(a) and 7(b), the high-frequency current suppressor 225 is fixed to the end of the earphone 211 in series with an internal circumference thereof being adhered to an external circumferencial surface 216a of the cable housing 216 of the signal cable 214.

Besides, the high-frequency current suppressor 225 is consisting of composite magnetic material which comprises soft magnetic powder obtained by flattening alloy powder including Fe, Si, Al, and binding material, similarly to the high-frequency current suppressor 215 according to the fifth embodiment. The high-frequency current suppressor 225 is formed by press molding to have the above-mentioned hollow taper shape and the size.

### (Seventh Embodiment) (Reference Embodiment)

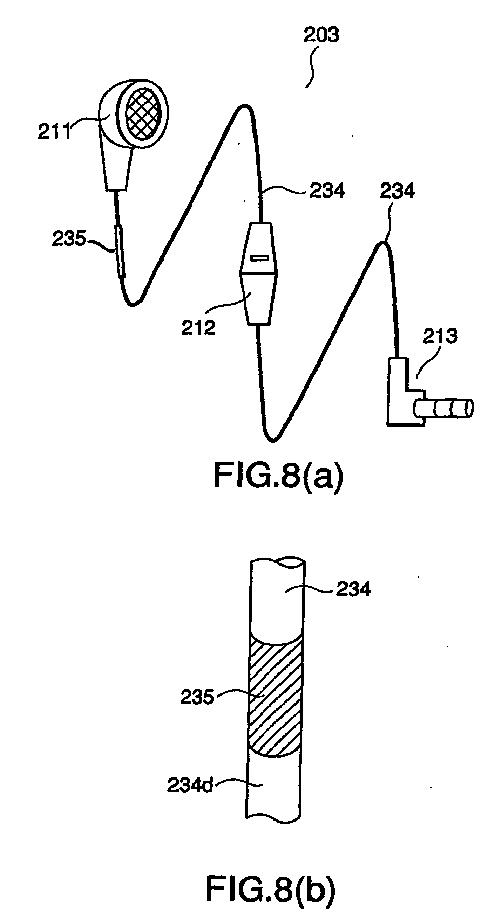

Continuously, referring to Figs. 8(a) and 8(b), description will proceed to an earphone system according to a seventh embodiment. The earphone system according to the seventh embodiment has a structure basically similar to that of the fifth embodiment illustrated in Figs. 6(a) and 6(b). Similar portions are therefore designated by like reference numerals and detailed description thereof is omitted accordingly.

As illustrated in Fig. 8(a), an earphone system 203 according to the seventh embodiment comprises a high-frequency current suppressor 235 attached to the signal cable 234 at a position near the earphone 211, similarly to that of the above-mentioned fifth embodiment. The signal cable 234 is, what we call, a coaxial cable. The signal cable 234 comprises unillustrated an inner conductor, an outer conductor, an insulation coating layer for insulating the inner conductor from the outer conductor, and an insulation cable housing for coating the outer conductor substantially all over the length thereof [only the insulation cable housing is shown by a reference numeral 234d in Fig. 8(b)]. In this earphone system 203 according to the seventh embodiment, the signal cable 234 includes a portion lacking of the insulation cable housing 234d near the earphone 211, as illustrated in Figs. 8(a) and 8(b). The high-frequency current suppressor 235 is formed on an exposed surface of the outer conductor in this portion.

Herein, the high-frequency current suppressor 235 is consisting of magnetic loss thin film (granular magnetic thin film) composed of Fe₇₂Al₁₁O₁₇. The high-frequency current suppressor 235 is formed to have a length of 5.5 mm and a film thickness of 1.5 µm on a surface of the outer conductor 234b.

### (Eighth Embodiment) (Reference Embodiment)

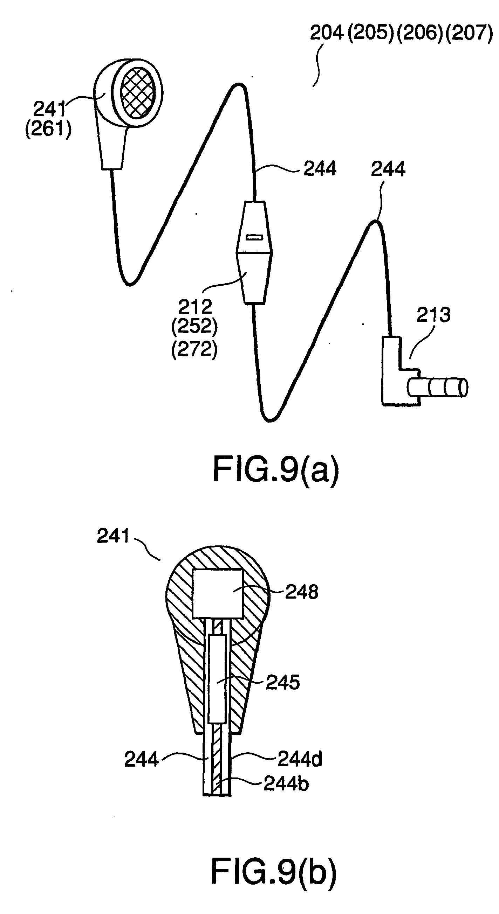

Further, referring to Figs. 9(a) and 9(b), description will proceed to an earphone system according to a eighth embodiment. As illustrated in Fig. 9(a), the earphone system 204 according to the eighth embodiment comprises an earphone 241, a microphone 212, a connection plug 213, and a signal cable 244 for connecting the earphone 241 and the microphone 212 as well as the microphone 242 and the connection plug 213. As illustrated in Fig. 9(b), the earphone 241 comprises a speaker portion 248. Similarly to the signal cable 234 of the above-mentioned seventh embodiment, the signal cable 244 comprises unillustrated an inner conductor, an outer conductor, an insulation coating layer for insulating the inner conductor from the outer conductor, and an insulation cable housing for coating the outer conductor substantially all over the length thereof [only the outer conductor 244b and the insulation cable housing 244d are shown in Fig. 9(b)]. Within the earphone 241, the inner conductor and the outer conductor 244b are connected to the speaker portion 248, respectively.

In this earphone system 204 according to the eighth embodiment, as illustrated in Fig. 9(a), no high-frequency current suppressor is attached to a portion near the earphone 241 or an end of the earphone 241. As illustrated in Fig. 9(b), a high-frequency current suppressor 245 is formed on a surface of the outer conductor 244b, in other words, between the outer conductor 244b and the insulation cable housing 244d.

Further, the high-frequency current suppressor 245 is consisting of magnetic loss thin film (granular magnetic thin film) composed of Fe₇₂Al₁₁O₁₇. The high-frequency current suppressor 245 is formed to have a length of 4.2 mm and a film thickness of 1.9 µm on the surface of the outer conductor 244b.

### (Ninth Embodiment) (Reference Embodiment)

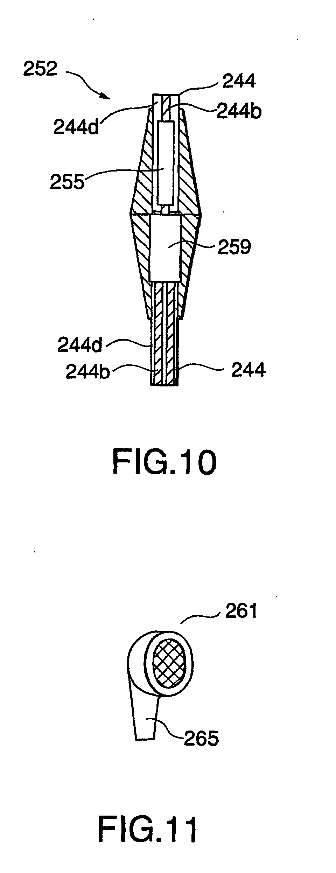

Further, referring to Fig. 10, description will proceed to an earphone system according to an ninth embodiment

The earphone system 205 according to the ninth embodiment has a basic structure similar to that of the eighth embodiment illustrated in Fig. 9(a). Illustration of the basic structure is omitted, but reference numerals of only different portions are designated by parentheses in Fig. 9(a). Namely, as illustrated in Fig. 9(a), the earphone system 205 according to the ninth embodiment comprises an earphone 241, a microphone 252, a connection plug 213, and a signal cable 244 for connecting the earphone 241 and the microphone 252 as well as the microphone 252 and the connection plug 213. As illustrated in Fig. 10, the microphone 252 comprises a microphone portion 259. Within the microphone 252, the inner conductor and the outer conductor 244b are connected to the microphone portion 259, respectively.

In this earphone system 205 according to the ninth embodiment, as illustrated in Fig. 9(a), no high-frequency current suppressor is attached to a portion near the microphone 252 or an end of the microphone 252. As illustrated in Fig. 10, a high-frequency current suppressor 255 is formed on a surface of the outer conductor 244b, in other words, between the outer conductor 244b and the insulation cable housing 244d inside of the microphone 252.

Further, the high-frequency current suppressor 255 is consisting of magnetic loss thin film (granular magnetic thin film) composed of Fe₇₂Al₁₁O₁₇. The high-frequency current suppressor 255 is formed to have a length of 4.2 mm and a film thickness of 1.9 µm on the surface of the outer conductor 244b.

### (Tenth Embodiment)

Further, referring to Fig. 11, description will proceed to an earphone system according to a tenth embodiment of the present invention.

The earphone system 206 according to the tenth embodiment has a basic structure similar to the earphone system 204 of the eighth embodiment illustrated in Fig. 9(a). Illustration of the basic structure is omitted, but reference numerals of only different portions are designated by parentheses in Fig. 9(a). Namely, as illustrated in Fig. 9(a), the earphone system 206 according to the tenth embodiment comprises an earphone 261, a microphone 212, a connection plug 213, and a signal cable 244 for connecting the earphone 261 and the microphone 212 as well as the microphone 212 and the connection plug 213.

In this earphone system 206 according to the tenth embodiment, as illustrated in Fig. 9(a), no high-frequency current suppressor is attached to a portion near the earphone 261 or an end of the earphone 261. As illustrated in Fig. 11, a high-frequency current suppressor itself is used as a molded resin constructing a case of the earphone 261.

Herein, the high-frequency current suppressor 265 is consisting of a resin including composite magnetic material which comprises soft magnetic powder obtained by flattening alloy powder including Fe, Si, Al, and binding material. The high-frequency current suppressor 265 is formed by press molding to have a structure illustrated in Fig. 11.

### (Eleventh Embodiment)

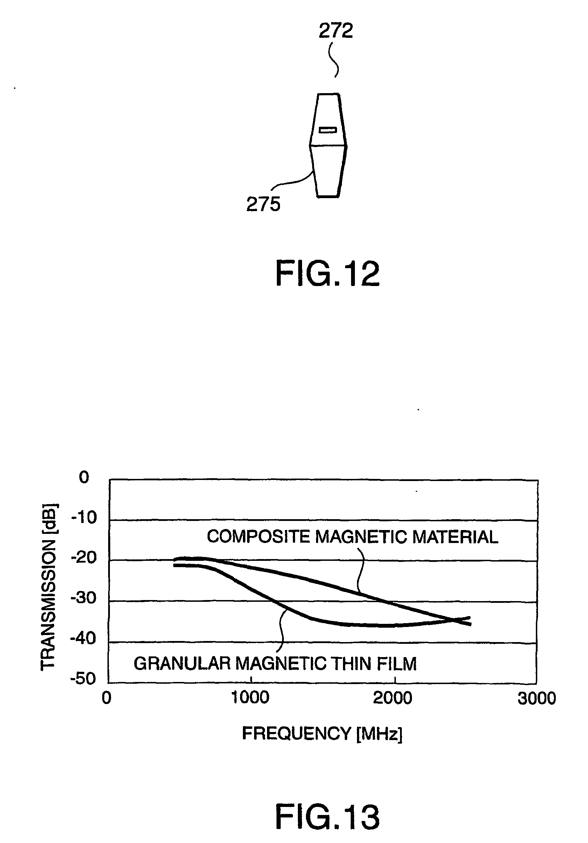

Further, referring to Fig. 12, description will proceed to an earphone system according to an eleventh embodiment of the present invention.

The earphone system 207 according to the eleventh embodiment has a basic structure similar to the earphone system 204 of the eighth embodiment illustrated in Fig. 9(a). Illustration of the basic structure is omitted, but reference numerals of only different portions are designated by parentheses in Fig. 9(a). Namely, as illustrated in Fig. 9(a), the earphone system 207 according to the eleventh embodiment comprises an earphone 241, a microphone 272, a connection plug 213, and a signal cable 244 for connecting the earphone 241 and the microphone 272 as well as the microphone 272 and the connection plug 213.

In this earphone system 207 according to the eleventh embodiment, as illustrated in Fig. 9(a), no high-frequency current suppressor is attached to a portion near the microphone 272 or an end of the microphone 272. As illustrated in Fig. 12, a high-frequency current suppressor 275 itself is used as a molded resin constructing a case of the microphone 272.

Herein, the high-frequency current suppressor 275 is consisting of a resin including composite magnetic material which comprises soft magnetic powder obtained by flattening alloy powder including Fe, Si, Al, and binding material. The high-frequency current suppressor 275 is formed by press molding to have a structure illustrated in Fig. 12.

Hereinunder, description will proceed to operations and effects of the earphone system according to the fifth through the eleventh embodiments. Fig. 13 shows measuring effects of suppressing effect against high-frequency electromagnetic waves in the earphone system using the high-frequency current suppressor according to the fifth through the eleventh embodiments.

In the measurement, at first, a tube having 2.5 mm in diameter and 15 mm in length, which has in its central a through hole having 0.5 mm in diameter is prepared. Next, a copper wire having 0.5 mm in diameter and 300 mm in length is penetrated through the through hole. The composite magnetic material is then attached to a central portion of the copper wire in the length direction thereof to obtain a primary line including a primary high-frequency current suppressor (depicted as " composite magnetic material" in Fig. 13). On the other hand, a granular magnetic thin film used in the seventh and the eighth embodiments is formed by sputtering on a external circumference of the above-mentioned copper line to have a length of 15 mm to obtain a secondary line including a secondary high-frequency current suppressor (depicted as "granular magnetic thin film" in Fig. 13). Both ends of the primary line including the primary high-frequency current suppressor are connected to a network analyzer to investigate transmission characteristics between two ports. Also both ends of the secondary line including the secondary high-frequency current suppressor are connected to the network analyzer to investigate transmission characteristics between two ports.

As a result, suppressing effects between 20dB and 35dB can be obtained at quasi-microwave band in any of the primary and the secondary high-frequency current suppressors. Besides, other than the high-frequency current suppressors depicted in the above embodiments, larger suppressing effects can be obtained by changing material composition or size thereof.

As described above, according to the earphone system of the fifth through the eleventh embodiments, a high-frequency current suppressor is added to an earphone or a microphone itself, alternatively, to a part of a signal cable for connecting the earphone or the microphone into a terminal equipment for mobile communication. High-frequency current generated in a signal cable by electromagnetic waves produced from the terminal equipment can be reduced. Therefore, it becomes possible to provide an earphone system which is able to prevent an increase of SAR value in a human head by the electromagnetic waves.

While this invention has thus far been described in specific conjunction with only several embodiments thereof, it will now be readily possible for one skilled in the art to put this invention into effect in various other manners. For example, in the above embodiments, an earphone system of the present invention was described as regards such an earphone system as used for a portable telephone. However, the earphone system of the present invention is not limited to such a use. The earphone system of the present invention can be applied to various electronic equipments for enjoying music or movies, in which an earphone or a headphone is generally used.

### INDUSTRIAL APPLICABILITY:

As described above, according to an aspect of the present invention, a high-frequency current suppressor can be readily attached and fixed to an earphone, a microphone, or a signal cable used for the other electronic equipments. Therefore, unnecessary high-frequency current can be reduced sufficiently. Accordingly, the present invention is effective enough to solve various EMI problems.

Further, according to another aspect of the present invention, high-frequency current generated by electromagnetic induction can be reduced by adding a high-frequency current suppressor to at least, an earphone, a headphone or a microphone itself, alternatively, a part of a signal cable for connecting those. Accordingly, the present invention is very effective to the increase of SAR value in a human head by the electromagnetic waves that has been seriously a problem in recent years.

## Claims

1. An earphone system (201; 202; 203; 204/205/206/207) comprising a connection plug (213) connected to an output terminal of an electronic equipment, an earphone (211; 241/261), and a signal cable (214; 234; 244) for connecting said connection plug (213) with said earphone, wherein said earphone system (201; 202; 203; 204/205/206/207) is provided with a high-frequency current suppressor (215; 225; 235; 245; 255; 265; 275), wherein said high-frequency current suppressor (215; 225; 235; 245; 255; 265; 275) is consisting of material selected from the following group: a composite magnetic material which comprises soft magnetic powder obtained by flattening alloy powder including at least Fe, Si, Al, and binding material;
a composite magnetic material which comprises soft magnetic powder obtained by flattening alloy powder including at least Ni, Fe, and binding material.

2. The earphone system as claimed in claim 1, wherein the high-frequency current suppressor (215; 225; 235; 245; 255; 265; 275) is added at least partially to any one of said connection plug (213), said earphone (211; 241/261)) and said signal cable (214; 234; 244).

3. The earphone system as claimed in claim 1, wherein a part or a whole of outer circumference of an outer conductor of said signal cable (214; 234; 244) is covered by said high-frequency current suppressor (215; 225; 235).

4. The earphone system as claimed in any one of claims 1 through 3, wherein said high-frequency current suppressor (245; 265) is included inside said earphone (241; 261).

5. The earphone system as claimed in claim 2, wherein a part or a whole of outer circumference (216a) of said signal cable (214) is covered by said high-frequency current suppressor (215; 225; 235) or a part or a whole of outer circumference of an outer conductor (244b) of said signal cable (214; 234; 244) is covered by said high-frequency current suppressor (215; 235; 245; 255).

6. The earphone system as claimed in claim 2 or 3, wherein the high-frequency current suppressor is made of a flexible member and has a break which elongates over all length along an axial direction of said cable.

7. The earphone system as claimed in claim 2 or 3, wherein said high-frequency current suppressor (215; 225; 235) is provided near a portion where said signal cable (214;234) and said earphone (211) are connected to each other.

8. The earphone system as claimed in claim 1, wherein said earphone system further comprises a microphone (212/252/272).

9. The earphone system as claimed in claim 8, wherein said high-frequency current suppressor (255;275) is included inside said microphone (252,272).

10. The earphone system as claimed in claim 8, wherein a housing of said earphone (261) or said microphone (272) is formed by said high-frequency current suppressor (265; 275).

## Patentansprüche

1. Hörkapselsystem (201; 202; 203; 204/205/206/207), umfassend einen Verbindungsstecker (213), der mit einem Ausgabeterminal eines elektronischen Geräts verbunden ist, eine Hörkapsel (211; 241/261), und ein Signalkabel (214; 234; 244) zum Verbinden des Verbindungssteckers (213) mit der Hörkapsel, wobei das Hörkapselsystem (201; 202; 203; 204/205/206/207) mit einem Hochfrequenzstromsuppressor (215; 225; 235; 245; 255; 265; 275) versehen ist, wobei der Hochfrequenzstromsuppressor (215; 225; 235; 245; 255; 265; 275) aus einem Material aufgebaut ist, das aus der folgenden Gruppe ausgewählt ist:
ein magnetisches Compositmaterial, welches weich-magnetisches Pulver, das durch Flachmachen von mindestens Fe, Si, Al einschließendem Legierungspulver erhalten wurde, und ein Bindematerial umfasst;
ein magnetisches Compositmaterial, welches weich-magnetisches Pulver, das durch Flachmachen von mindestens Ni, Fe einschließendem Legierungspulver erhalten wurde, und ein Bindematerial umfasst.

2. Hörkapselsystem wie im Anspruch 1 beansprucht, wobei der Hochfrequenzstromsuppressor (215; 225; 235; 245; 255; 265; 275) mindestens teilweise zu irgendeinem der Bestandteile Verbindungsstecker (213), Hörkapsel (211; 241/261) und Signalkabel (214; 234; 244) hinzugefügt ist.

3. Hörkapselsystem wie im Anspruch 1 beansprucht, wobei ein Teil oder eine Gesamtheit des äußeren Umfangs eines äußeren Leiters des Signalkabels (214; 234; 244) mit dem Hochfrequenzstromsuppressor (215; 225; 235) bedeckt ist.

4. Hörkapselsystem wie in irgendeinem der Ansprüche 1 bis 3 beansprucht, wobei der Hochfrequenzstromsuppressor (245; 265) im Inneren der Hörkapsel (241; 261) eingeschlossen ist.

5. Hörkapselsystem wie im Anspruch 2 beansprucht, wobei ein Teil oder eine Gesamtheit des äußeren Umfangs (216a) des Signalkabels (214) mit dem Hochfrequenzstromsuppressor (215; 225; 235) bedeckt ist oder ein Teil oder eine Gesamtheit des äußeren Umfangs eines äußeren Leiters (244b) des Signalkabels (214; 234; 244) mit dem Hochfrequenzstromsuppressor (215; 235; 245; 255) bedeckt ist.

6. Hörkapselsystem wie im Anspruch 2 oder 3 beansprucht, wobei der Hochfrequenzstromsuppressor aus einem flexiblen Teil gefertigt ist und eine Unterbrechung aufweist, die sich über die gesamte Länge entlang einer Axialrichtung des Kabels erstreckt.

7. Hörkapselsystem wie im Anspruch 2 oder 3 beansprucht, wobei der Hochfrequenzstromsuppressor (215; 225; 235) in der Nähe eines Abschnitts vorgesehen ist, wo das Signalkabel (214; 234) und die Hörkapsel (211) miteinander verbunden sind.

8. Hörkapselsystem wie im Anspruch 1 beansprucht, wobei das Hörkapselsystem ferner ein Mikrophon (212/252/272) umfasst.

9. Hörkapselsystem wie im Anspruch 8 beansprucht, wobei der Hochfrequenzstromsuppressor (255; 275) im Inneren des Mikrophons (252/272) eingeschlossen ist.

10. Hörkapselsystem wie im Anspruch 8 beansprucht, wobei ein Gehäuse der Hörkapsel (261) oder des Mikrophons (272) aus dem Hochfrequenzstromsuppressor (265; 275) gebildet ist.

## Revendications

1. Système d'écouteur (201 ; 202 ; 203 ; 204/205/206/207) comprenant une fiche de branchement (213) connectée à une borne de sortie d'un équipement électronique, un écouteur (211 ; 241/261), et un câble de signaux (214 ; 234 ; 244) pour connecter la fiche de branchement (213) à l'écouteur,
dans lequel
le système d'écouteur (201 ; 202 ; 203 ; 204/205/206/207) est muni d'un dispositif de suppression de courant haute fréquence (215 ; 225 ; 235 ; 245 ; 255 ; 265 ; 275), ce dispositif de suppression de courant haute fréquence (215 ; 225 ; 235 ; 245 ; 255 ; 265 ; 275) étant constitué d'un matériau sélectionné dans le groupe suivant comprenant :
un matériau magnétique composite constitué d'une poudre magnétique douce obtenue en étalant une poudre d'alliage comprenant au moins Fe, Si, Al, et un matériau de liant ;
un matériau magnétique composite constitué d'une poudre magnétique douce obtenue en étalant une poudre d'alliage comprenant au moins Ni, Fe, et un matériau de liant.

2. Système d'écouteur selon la revendication 1,
dans lequel
le dispositif de suppression de courant haute fréquence (215 ; 225 ; 235 ; 245 ; 255 : 265 : 275) est ajouté au moins en partie à l'un quelconque de la prise de branchement (213), de l'écouteur (211 ; 241/261), et du câble de signaux (214 ; 234 ; 244).

3. Système d'écouteur selon la revendication 1,
dans lequel
une partie ou la totalité de la circonférence extérieure d'un conducteur extérieur du câble de signaux (214 ; 234 ; 244) est recouverte par le dispositif de suppression de courant haute fréquence (215 ; 225 ; 235).

4. Système d'écouteur selon l'une quelconque des revendications 1 à 3,
dans lequel
le dispositif de suppression de courant haute fréquence (245 ; 265) est inclus dans l'écouteur (241 ; 261).

5. Système d'écouteur selon la revendication 2,
dans lequel
une partie ou la totalité de la circonférence extérieure (216a) du câble de signaux (214) est recouverte par le dispositif de suppression de courant haute fréquence (215 ; 225 ; 235), ou encore une partie ou la totalité de la circonférence extérieure d'un conducteur extérieur (244b) du câble de signaux (214 ; 234 ; 244) est recouverte par le dispositif de suppression de courant haute fréquence (215 ; 235 ; 245 ; 255).

6. Système d'écouteur selon la revendication 2 ou 3,
dans lequel
le dispositif de suppression de courant haute fréquence est réalisé dans un matériau souple et comporte une brèche qui s'allonge sur toute la longueur, suivant la direction axiale du câble.

7. Système d'écouteur selon la revendication 2 ou 3,
dans lequel
le dispositif de suppression de courant haute fréquence (215 ; 225 ; 235) est prévu au voisinage d'une partie où le câble de signaux (214 ; 234) et l'écouteur (211) sont connectés l'un à l'autre.

8. Système d'écouteur selon la revendication 1,
dans lequel
le système d'écouteur comprend en outre un microphone (212/252/272).

9. Système d'écouteur selon la revendication 8.
dans lequel
le dispositif de suppression de courant haute fréquence (255 ; 275) est inclus dans le microphone (252/272).

10. Système d'écouteur selon la revendication 8,
dans lequel
un boîtier de l'écouteur (261) ou du microphone (272) est formé par le dispositif de suppression de courant haute fréquence (265 ; 275).
